# EUROPEAN PATENT APPLICATION

(11) **EP 4 657 506 A1**
(43) Date of publication of application: **03.12.2025**
(21) Application number: 24747264.0
(22) Date of filing: 22.01.2024
(51) Int. Cl.: H01L 21/304, C11D 1/12, C11D 7/08, C11D 7/26, C11D 7/32, C11D 7/34

(54) **CLEANING COMPOSITION FOR SILICON CARBIDE SUBSTRATE**

(30) Priority: 23.01.2023 JP 2023008372
(71) Applicant: Kanto Kagaku Kabushiki Kaisha, Tokyo 103-0023 (JP)
(72) Inventor: MORITA, Kikue, Tokyo 103-0022 (JP); TAKANAKA, Areji, Soka-shi, Saitama 340-0003 (JP)
(74) Representative: Meissner Bolte Partnerschaft mbB
(86) International application number: PCT/JP2024/001679
(87) International publication number: WO 2024/157937

(57) **Abstract**

Provided is a cleaning composition for manganese contamination of a silicon carbide substrates, the cleaning composition having high stability and enabling transport of a product in the form of a solution.

A cleaning liquid composition for cleaning a silicon carbide substrate polished by an abrasive containing a manganese compound or a silicon carbide substrate etched by an etchant containing a manganese compound, the cleaning liquid composition containing a reducing agent, a pH adjusting agent, and water, having a pH of less than 5, and the reducing agent being at least one selected from the group consisting of glyoxylic acid, diethylhydroxylamine, and six-membered ring compounds in which two or more hydroxyl groups are directly bonded to a ring.

## Description

### [Technical Field]

The present invention relates to a composition for cleaning silicon carbide substrates and a method for cleaning silicon carbide substrates.

### [Background Arts]

Silicon carbide (SiC) has excellent physical properties, such as a wide band-gap, high dielectric breakdown field strength, and high thermal conductivity, compared to silicon, which is currently the mainstream semiconductor material. Therefore, it is expected to be a semiconductor material for power devices that enable high-power control and energy savings.

The device manufacturing process generally includes a polishing step to flatten the substrate and an etching step to dissolve and remove layers damaged by processing. However, silicon carbide is so solid that it can hardly be polished or etched by polishing with silica slurry or by etching with strong acids such as fluoronitric acid, which have conventionally been used in processing silicon substrates, and thus has a problem of requiring a long time for processing. In order to address this problem, methods have been proposed in which permanganate ions are added as an oxidizing agent to the slurry or etchant, or in which manganese oxide is used as an abrasive grain in the slurry. Nevertheless, this causes a high concentration of manganese contamination to be remained on the silicon carbide after polishing or etching.

Manganese oxides used as abrasive grains include MnO₂ and Mn₃O₄, though manganese compounds with a valence of III or IV are insoluble, and it is presumed that permanganate compounds added to slurries or etchants would produce insoluble manganese compounds. Once such insoluble manganese compounds are deposited on a substrate, it is very difficult to clean them off.

RCA cleaning is widely used for cleaning silicon carbide, and its basic form is a combination of SC-1 cleaning (Standard Clean 1) composed of ammonia solution and hydrogen peroxide solution to remove particles, SC-2 cleaning (Standard Clean 2) composed of hydrochloric acid and hydrogen peroxide solution to remove metal impurities, and cleaning with hydrofluoric acid.

As a cleaning method other than RCA cleaning, Patent Document 1 proposes a cleaning agent that contains at least one of ascorbic acid and erythorbic acid and that has a pH of 6 or less. Patent Document 2 proposes a method for cleaning a semiconductor substrate using a reducing agent such as ascorbic acid and an acid.

### [Prior Art Documents]

### [Patent Documents]

| | |
|---|---|
| [Patent Document 1] | WO 2013/088928 |
| [Patent Document 2] | JP A 11-251280 |

### [Summary of the Invention]

### [Problem to be Solved by the Invention]

The RCA cleaning, which is widely used for cleaning silicon carbide, has problems in that it poses a large burden on safety and the environment because it uses highly concentrated strong acidic and strong alkaline cleaning solutions at high temperatures and also uses highly toxic hydrofluoric acid at high concentrations. Patent Documents 1 and 2 propose cleaning agents containing the reducing agents ascorbic acid or erythorbic acid. However, ascorbic acid and erythorbic acid have strong reducing power and are easily oxidized and decomposed in solution, resulting in a rapid decrease in their content, making it impossible to transport the products of cleaning agent in the form of a solution. This meant that the cleaning solution had to be prepared at the user's site from ascorbic acid or erythorbic acid that had been transported in solid form, necessitating the installation of preparation equipment and filtration equipment for cleaning solution, causing problems such as increased labor hours and costs.

An object of the present invention is to provide a cleaning liquid composition for cleaning manganese contamination on a silicon carbide substrate, having excellent safety and stability and capable of being delivered as a product in the form of a solution.

### [Means for Solving Problems]

In the course of intensive research aimed at solving the above problems, the present inventors discovered that a specific reducing agent selected from the group consisting of a six-membered ring compound having two or more hydroxyl groups directly bound to the ring, glyoxylic acid, and diethylhydroxylamine can effectively remove manganese compounds on a silicon carbide substrate under acidic conditions. As a result of further research, the present inventors have completed the present invention.

That is, the present invention relates to the followings:
[1] A cleaning liquid composition for cleaning a silicon carbide substrate that has been polished with an abrasive containing a manganese compound or a silicon carbide substrate that has been etched with an etchant containing a manganese compound, the cleaning liquid composition comprising a reducing agent, a pH adjuster and water, and having a pH of less than 5, wherein the reducing agent being one or more selected from the group consisting of a six-membered ring compound having two or more hydroxyl groups directly bound to the ring, glyoxylic acid and diethylhydroxylamine.
[2] The composition according to [1] above, comprising a six-membered ring compound having two or more hydroxyl groups directly bound to the ring represented by the following formula (1): 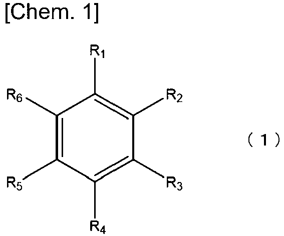 wherein:
   R¹ to R⁶ are each independently H, OH, COOH, an alkyl having 1 to 4 carbon atoms, an alkenyl having 2 to 4 carbon atoms, or an alkoxy having 1 to 4 carbon atoms, wherein at least two of R¹ to R⁶ are OH.
[3] The cleaning liquid composition according to [1] or [2], comprising one or more six-membered ring compounds having two or more hydroxyl groups directly bound to the ring, wherein the one or more six-membered ring compounds being selected from the group consisting of gallic acid, catechol, resorcinol, hydroquinone, pyrogallol and methylcatechol.
[4] The cleaning liquid composition according to any one of the above [1] to [3], wherein the pH adjuster is an inorganic acid or an organic acid.
[5] The cleaning liquid composition according to any one of [1] to [4] above, wherein the pH adjuster is selected from the group consisting of hydrochloric acid, sulfuric acid, nitric acid, phosphoric acid, methanesulfonic acid, oxalic acid, malonic acid, succinic acid, malic acid, tartaric acid and citric acid.
[6] The cleaning liquid composition according to any one of [1] to [5] above, further comprising one or more polysulfonic acid compounds as a surfactant.
[7] The cleaning liquid composition according to any one of [1] to [6] above, wherein the concentration of the reducing agent is equal to or more than 0.001% by mass and equal to or less than 1% by mass.
[8] A stock liquid composition for a cleaning liquid composition according to any one of [1] to [7] above, which is used by being diluted 10 to 1,000 times to give the cleaning liquid composition.
[9] A method for cleaning a silicon carbide substrate, comprising a step of contacting the cleaning liquid composition according to any one of [1] to [7] above with a silicon carbide substrate that has been polished with an abrasive containing a manganese compound, or with a silicon carbide substrate that has been etched with a composition containing a manganese compound.

### [Advantageous Effects of the Invention]

According to the cleaning liquid composition of the present invention, manganese compounds on a silicon carbide substrate can be safely and conveniently removed by using a reducing agent selected from the group consisting of a six-membered ring compound having two or more hydroxyl groups directly bound to a ring, glyoxylic acid, and diethylhydroxylamine under acidic conditions. Although the mechanism is not entirely clear, it is believed that the reducing agent used in the present invention acts stably on insoluble manganese compounds under acidic conditions, and reduces insoluble manganese compounds with valences III and IV to highly soluble manganese compounds with valences II, which then dissolve in the cleaning composition, and as a result the manganese compounds would be removed.

The cleaning liquid composition of the present invention does not contain highly toxic components and does not require a cleaning process using multiple cleaning liquids as in RCA cleaning. Moreover, since the cleaning liquid composition of the present invention does not require consideration about oxidative decomposition of the reducing agent, etc., it can be transported in the form of a solution, and there is no need to prepare a cleaning liquid when being used. Therefore, the cleaning liquid composition of the present invention can save each user the trouble of installing preparation equipment and preparing the composition, and also greatly contributes to reducing the manufacturing costs of silicon carbide devices.

### [Description of Embodiments]

Hereinbelow, preferred embodiments of the cleaning composition for silicon carbide substrates and the cleaning method for silicon carbide substrates according to the present invention will be described in detail.

The cleaning liquid composition of the present invention is used for cleaning a silicon carbide substrate which has been polished with an abrasive containing a manganese compound, or a silicon carbide substrate which has been etched with an etchant containing a manganese compound.

The cleaning composition of the present invention can remove manganese contamination remaining on a silicon carbide substrate that has been treated with an abrasive or an etchant containing a manganese compound. The silicon carbide substrate is not particularly limited as long as it has a silicon carbide layer on the surface of the substrate, and the silicon carbide may be either single crystal silicon carbide or epitaxial silicon carbide.

The manganese compounds contained in the abrasive and etchant are manganese compounds that are usually used in abrasives or etchants, including, for example, manganese dioxide, dimanganese trioxide, permanganate salts, and the like.

The manganese compounds remaining on the silicon carbide substrate may include, in addition to the manganese compounds described above, those in the form of ions such as manganese ions and permanganese ions.

The reducing agent contained in the cleaning liquid composition of the present invention is not limited as long as it is capable of changing the valence of the insoluble manganese compound. From the viewpoint of being able to stably and effectively reduce the insoluble manganese compound under acidic conditions, a six-membered ring compound having two or more hydroxyl groups directly bound to the ring, glyoxylic acid, and diethylhydroxylamine are preferred. The reducing agents can be used alone or in combination of two or more.

The six-membered ring compound having two or more hydroxyl groups directly bound to the ring is not particularly limited as long as it is capable of effectively reducing the insoluble manganese compound, though it is, for example, a compound represented by the following formula (1). 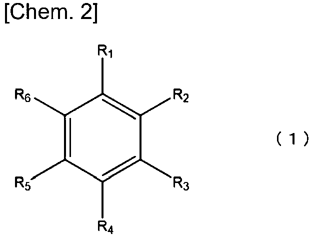 In the formula,
R¹ to R⁶ are each independently H, OH, COOH, an alkyl having 1 to 4 carbon atoms, an alkenyl having 2 to 4 carbon atoms, or an alkoxy having 1 to 4 carbon atoms, wherein at least two, preferably two or three of R¹ to R⁶ are OH.

The six-membered ring compounds having two or more hydroxyl groups directly bound to the ring stably acts as a reducing agent on insoluble manganese compounds under an acidic condition, and is capable of reducing the same. The six-membered ring compound having two or more hydroxyl groups directly bound to the ring includes, in specific, gallic acid, catechol, resorcinol, hydroquinone, pyrogallol, 1,2,4-trihydroxybenzene, methylcatechol, methylhydroquinone and tert-butylhydroquinone, of which gallic acid and pyrogallol being particularly preferred.

The concentration of the reducing agent is not particularly limited, though it is, for example, equal to or higher than 0.0001% by mass, and more preferably equal to or higher than 0.001% by mass. This enables a manganese compound to be sufficiently and efficiently reduced from a valence III or IV to a valence II manganese compound. The upper limit of the concentration of the reducing agent is not particularly limited, though it is, for example, equal to or less than 10% by mass, more preferably equal to or less than 1% by mass. In one embodiment of the present invention, the concentration of the reducing agent is equal to or higher than 0.0001% by mass and equal to or less than 10% by mass, and in a preferred embodiment, the concentration of the reducing agent is equal to or higher than 0.001% by mass and equal to or less than 1% by mass.

The pH adjuster contained in the cleaning liquid composition of the present invention is not particularly limited as long as it can adjust the pH of the cleaning composition to an acidic state. The pH adjuster, in combination with the reducing agent, has effects of releasing the manganese compounds remaining on the silicon carbide substrate from the substrate surface and dissolving them in the cleaning composition. Such pH adjusters include, for example, inorganic acids and organic acids, of which one may be used alone or two or more can be used in combination.

The inorganic acids include hydrofluoric acid, hydrochloric acid, sulfuric acid, nitric acid, phosphoric acid, and perchloric acid. Preferably, the cleaning liquid composition of the present invention comprises one or more inorganic acids selected from the group consisting of hydrochloric acid, sulfuric acid, nitric acid, and phosphoric acid.

The organic acids include organic sulfonic acids such as methanesulfonic acid and ethanesulfonic acid, aliphatic monocarboxylic acids such as formic acid, acetic acid and propionic acid, dicarboxylic acids such as oxalic acid, malonic acid and succinic acid, and oxypolycarboxylic acids such as tartaric acid, malic acid and citric acid. Preferably, the cleaning liquid composition of the present invention comprises one or more organic acids selected from the group consisting of methanesulfonic acid, oxalic acid, malonic acid, succinic acid, malic acid, tartaric acid and citric acid.

In a preferred embodiment, the cleaning liquid composition of the present invention comprises at least one pH adjuster selected from the group consisting of sulfuric acid, nitric acid, phosphoric acid, methanesulfonic acid, oxalic acid, malonic acid, succinic acid, malic acid, tartaric acid and citric acid.

The pH of the cleaning liquid composition of the present invention is preferably acidic, and is preferably less than 5, more preferably equal to or less than 4, and further preferably equal to or less than 3. This enables the manganese compounds on the surface of the silicon carbide substrate to be dissolved in the cleaning liquid composition in an appropriate manner, thereby removing the manganese compounds from the surface of the silicon carbide substrate. When the pH is equal to or higher than 5, the solubility decreases, and the removing performance would be impaired.

The concentration of the pH adjuster is not particularly limited as long as it is an amount necessary to adjust the pH to an acidic state, and is, for example, 0.0001 to 10% by mass, preferably 0.001 to 1.0 % by mass, and particularly preferably 0.01 to 1.0 % by mass. If the concentration of the pH adjuster exceeds the above range, the equipment may be corroded.

The cleaning liquid composition of the present invention may comprise a surfactant in order to improve the performance in removing minute particles. The type of surfactant may be selected as appropriate, and a preference is given to polysulfonic acid compounds, without being limited thereto. The polysulfonic acid compounds include, for example, naphthalenesulfonic acid formaldehyde condensates, polystyrenesulfonic acid, lignin sulfonic acid, and salts thereof. In a preferred embodiment, the cleaning liquid composition of the present invention comprises one or more polysulfonic acid compounds.

The concentration of the surfactant in the cleaning liquid composition of the present invention is not particularly limited, though it is, for example, 0.0001 to 10 % by mass, preferably 0.001 to 1.0 % by mass, and particularly preferably 0.001 to 0.1 % by mass. Above the range described above, the effect of improving the performance of removing minute particles would increase less. Therefore, it is economical to use the surfactant within the above range.

Moreover, the cleaning liquid composition of the present invention usually comprises a solvent. The solvent is not particularly limited, though water is generally used. However, the cleaning liquid composition of the present invention may comprise an organic solvent as a solvent.

Such organic solvents include, for example, various organic solvents that are miscible with water, such as alcohol type solvents, ether type solvents, and ketone type solvents, of which one may be used alone or two or more can be used in combination.

The alcohol type solvents include aliphatic alcohol type solvents such as methanol, ethanol, and propanol, glycol solvents such as ethylene glycol, and other polyhydric alcohols such as glycerin.

The water content in the cleaning liquid composition of the present invention is not particularly limited, though it is, for example, 10 to 99.99 % by mass, preferably 50 to 99.99 % by mass, and particularly preferably 80 to 99.99 % by mass.

The concentration of the organic solvent in the present invention is not particularly limited, though it is, for example, 0.0001 to 20% by mass, preferably 0.001 to 10% by mass, and particularly preferably 0.01 to 1% by mass.

In the cleaning liquid composition of the present invention, it is preferred that each component is used at the concentration described above. However, since high-concentration products in which the concentration of each component is 10 to 1,000 times higher are also stable, high-concentration products can be prepared for storage, transportation, etc., and these high-concentration products can also be diluted when being used.

Therefore, the present invention also relates to a stock liquid composition for the cleaning liquid composition of the present invention, which is used by being diluted 10 to 1,000 times to give the cleaning liquid composition of the present invention.

When the stock liquid composition is diluted upon use, it can be diluted 10 to 1000 times with the above-mentioned water or organic solvent, or a mixture of water and the organic solvent.

Next, a method for cleaning a silicon carbide substrate according to the present invention will be described. The cleaning method of the present invention comprises the step of contacting the above-mentioned cleaning composition of the present invention with a silicon carbide substrate. The step of contacting includes, but is not limited to, a cleaning step after etching or polishing such as CMP. Methods for contacting include, but are not limited to, a single-wafer cleaning method combined with brush scrubbing, a batch spray cleaning method, and a batch cleaning method, etc.

The contacting step is performed in an atmosphere, for example, in the air, in a nitrogen atmosphere, or in vacuo, though it is not limited thereto. Among these, it is performed preferably in the air and in a nitrogen atmosphere. The duration for the contacting is selected as appropriate depending on the purpose, and is not limited, though it is 0.5 to 5 minutes in the case of a single-wafer cleaning method combined with brush scrubbing and a single-wafer cleaning method in which a cleaning solution is sprayed from a spray or a nozzle, and 0.5 to 30 minutes in the case of a batch spray cleaning method and a batch immersion cleaning method.

The temperature is not limited, though it is 20 to 50 °C in the case of a single-wafer cleaning method combined with brush scrubbing and a single-wafer cleaning method in which a cleaning solution is sprayed from a spray or a nozzle, and 20 to 100 °C in the case of a batch spray cleaning method and a batch immersion cleaning method. The above conditions can be combined as appropriate depending on the purpose.

The present invention has been described in detail above based on preferred embodiments. However, the present invention is not limited to these, and each component can be replaced with any component that is capable of performing a similar function, or any component can be added.

### [Examples]

Hereinbelow, the present invention will be described in more detail below with reference to examples, though the present invention is not limited to these examples.

### (Examples 1 to 6 and Comparative Examples 1 to 4)

### <Cleaning performance of cleaning composition (Mn surface concentration)>

### (1) Preparing cleaning composition

The components shown in Table 1 were mixed with water to give the concentrations shown in Table 1, to obtain cleaning compositions of Examples 1 to 6 and Comparative Examples 1 to 4.

### (2) Preparing test substrate

A silicon carbide substrate was washed with a mixture of hydrogen peroxide solution (30 wt%) and sulfuric acid (96 wt%) (volume ratio=1:6), and then contaminated with contaminated water prepared by dissolving potassium permanganate in water using a spin coating method such that the surface concentration of manganese (Mn) was 10¹³ atoms/cm². The contaminated substrate was immersed in each cleaning solution at room temperature for 3 minutes without stirring, then the substrate was taken out and rinsed with running ultrapure water for 3 minutes and dried to obtain a substrate for measurement.

### (3) Evaluating Mn cleaning performance

The Mn concentration on the surface of the substrate for measurement as described above was measured by TXRF (total reflection X-ray fluorescence analyzer, from Rigaku Holdings Corporation, model number: 3800e) to evaluate the cleaning performance of the cleaning composition. The Mn concentration was evaluated in terms of the number of Mn atoms per 1 cm2 of the substrate. The results corresponding to each cleaning composition are shown in Table 1.

The obtained results show that the cleaning composition of the present invention satisfactorily removes manganese under acidic conditions.

**[Table 1]**

| | Type of reducing agent | Reducing agent conc. [wt%] | Surfactant conc. [wt%] | pH adjuster | pH | Mn conc. x 10¹⁰ [atoms/cm2] |
|---|---|---|---|---|---|---|
| Initial contamination level | | | | | | 2700 |
| Comparative Example 1 | diethylhydroxylamine | 0.5 | - | - | 10 | 1200 |
| Comparative Example 2 | - | - | - | citric acid | 2 | 1300 |
| Comparative Example 3 | - | - | - | oxalic acid | 2 | 400 |
| Comparative Example 4 | - | - | - | hydrochloric acid | 1 | 740 |
| Example 1 | glyoxylic acid | 0.5 | - | oxalic acid | 2 | 91 |
| Example 2 | pyrogallol | 0.5 | - | hydrochloric acid | 2 | 4 |
| Example 3 | diethylhydroxylamine | 0.5 | - | citric acid | 3 | 27 |
| Example 4 | diethylhydroxylamine | 0.3 | - | hydrochloric acid | 2 | 3 |
| Example 5 | resorcinol | 0.2 | - | hydrochloric acid | 2 | 7 |
| Example 6 | pyrogallol | 0.2 | 0.03 | citric acid | 3 | 3 |

## Claims

1. A cleaning liquid composition for cleaning a silicon carbide substrate that has been polished with an abrasive containing a manganese compound or a silicon carbide substrate that has been etched with an etchant containing a manganese compound, the cleaning liquid composition comprising a reducing agent, a pH adjuster and water, and having a pH of less than 5, wherein the reducing agent being one or more selected from the group consisting of a six-membered ring compound having two or more hydroxyl groups directly bound to the ring, glyoxylic acid and diethylhydroxylamine.

2. The composition according to claim 1, comprising a six-membered ring compound having two or more hydroxyl groups directly bound to the ring represented by the following formula (1): 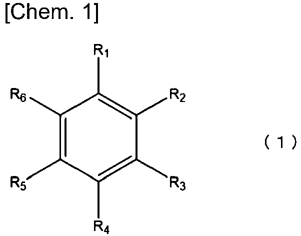 wherein:
R¹ to R⁶ are each independently H, OH, COOH, an alkyl having 1 to 4 carbon atoms, an alkenyl having 2 to 4 carbon atoms, or an alkoxy having 1 to 4 carbon atoms, wherein at least two of R¹ to R⁶ are OH.

3. The cleaning liquid composition according to Claim 1 or 2, comprising one or more six-membered ring compounds having two or more hydroxyl groups directly bound to the ring, wherein the one or more six-membered ring compounds being selected from the group consisting of gallic acid, catechol, resorcinol, hydroquinone, pyrogallol and methylcatechol.

4. The cleaning liquid composition according to any one of Claims 1 to 3, wherein the pH adjuster is an inorganic acid or an organic acid.

5. The cleaning liquid composition according to any one of Claims 1 to 4, wherein the pH adjuster is selected from the group consisting of hydrochloric acid, sulfuric acid, nitric acid, phosphoric acid, methanesulfonic acid, oxalic acid, malonic acid, succinic acid, malic acid, tartaric acid and citric acid.

6. The cleaning liquid composition according to any one of Claims 1 to 5, further comprising one or more polysulfonic acid compounds as a surfactant.

7. The cleaning liquid composition according to any one of Claims 1 to 6, wherein the concentration of the reducing agent is equal to or more than 0.001% by mass and equal to or less than 1% by mass.

8. A stock liquid composition for a cleaning liquid composition according to any one of Claims 1 to 7, which is used by being diluted 10 to 1,000 times to give the cleaning liquid composition.

9. A method for cleaning a silicon carbide substrate, comprising a step of contacting the cleaning liquid composition according to any one of Claims 1 to 7 with a silicon carbide substrate that has been polished with an abrasive containing a manganese compound, or with a silicon carbide substrate that has been etched with a composition containing a manganese compound.
